# EUROPEAN PATENT APPLICATION

(11) **EP 4 554 341 A1**
(43) Date of publication of application: **14.05.2025**
(21) Application number: 24195800.8
(22) Date of filing: 22.08.2024
(51) Int. Cl.: H05K 1/11, H05K 1/02, H05K 3/24, H01R 12/72, H05K 1/14

(54) **PRINTED CIRCUIT BOARD, MEMORY MODULE INCLUDING THE SAME, AND METHOD OF MANUFACTURING PRINTED CIRCUIT BOARD**

(30) Priority: 10.11.2023 KR 20230155647; 05.12.2023 KR 20230174936
(71) Applicant: Samsung Electronics Co., Ltd., Gyeonggi-do, 16677 (KR)
(72) Inventor: HAN, Youngbong, Suwon-si, Gyeonggi-do 16677 (KR); JIN, Jungho, Suwon-si, Gyeonggi-do 16677 (KR); KIM, Kyoungsun, Suwon-si, Gyeonggi-do 16677 (KR); KIM, Dohyung, Suwon-si, Gyeonggi-do 16677 (KR)
(74) Representative: Kuhnen & Wacker Patent- und Rechtsanwaltsbüro PartG mbB

(57) **Abstract**

A printed circuit board, PCB, (100) may include a main body (110) having an edge (110E) and a first surface (110S) on which a semiconductor chip (10) is provided, a first pin (121) including a first tab (121TAB) extending in a first direction (D1) that is perpendicular to the edge of the main body (110) and configured to receive a first signal corresponding to communication between the outside and the semiconductor chip (10) and a first tie-bar (121TB) protruding from an end of the first tab (121TAB) toward the edge (110E) of the main body (110), the first tie-bar having a first length, and a second pin (122) including a second tab (122TAB) extending in the first direction (D1) and configured to receive a ground voltage of a ground, and a second tie-bar (122TB) protruding from an end of the second tab (122TAB) toward the edge (110E) of the main body (110), the second tie-bar (122TB) having a second length that is greater than the first length.

## Description

### BACKGROUND

Example embodiments of the disclosure relate to an electronic device and a manufacturing method thereof, and more specifically, to a printed circuit board (PCB), a memory module including the same, and a method of manufacturing the PCB.

In general, a central processing unit (CPU), such as a microcomputer and expansion boards for peripheral devices, may be mounted on a main board of a personal computer. The CPU may generally be mounted on the main board in a socket manner or a slot manner. In addition, the expansion boards may be mounted on the main board by being inserted into expansion slots such as peripheral component interconnect (PCI) express slots.

Semiconductor memory is widely used to store data in various electronic devices such as computers and wireless communication devices. As one type of semiconductor memory, dynamic random access memory (DRAM) operates in a manner of writing and reading data by charges stored in a cell capacitor of a memory cell. The semiconductor memory may be mounted on a PCB, and the PCB, at least one semiconductor memory, and the like may be configured as a memory module.

A connection pin or a contact tab may be formed on a PCB for a memory module, and the PCB may be inserted into a slot provided in a main board or the like. The memory module may be a single in-line memory module (SIMM) structure in which tabs are formed on one surface and a dual in-line memory module (DIMM) structure in which tabs are formed on both surfaces.

Information disclosed in this Background section has already been known to or derived by the inventors before or during the process of achieving one or more embodiments of the present application, or is technical information acquired in the process of achieving one or more embodiments. Therefore, it may contain information that does not form prior art that is already known to the public.

### SUMMARY

One or more example embodiments provide a printed circuit board (PCB) that may reduce damage to a relatively weak signal pin when the PCB is mounted in a slot and may improve resistance and robustness to an electro-static discharge (ESD) of the memory module, as well as a memory module including the PCB, and a method of manufacturing the PCB.

Additional aspects will be set forth in part in the description which follows and, in part, will be apparent from the description, or may be learned by practice of the presented embodiments. Embodiments of the invention are set out in the appended claims.

According to an aspect of an example embodiment, a PCB may include a main body having an edge and a first surface on which a semiconductor chip is provided, a first pin including a first tab extending in a first direction that is perpendicular to the edge of the main body and configured to receive a first signal corresponding to communication between the outside and the semiconductor chip and a first tie-bar protruding from an end of the first tab toward the edge of the main body, the first tie-bar having a first length, and a second pin including a second tab extending in the first direction and configured to receive a ground voltage of a ground, and a second tie-bar protruding from an end of the second tab toward the edge of the main body, the second tie-bar having a second length that is greater than the first length.

According to an aspect of an example embodiment, a memory module may include a semiconductor chip, and a PCB including a main body on which the semiconductor chip is provided, a first pin spaced apart from an edge of the main body by a first distance, the first pin including an end terminal to which a first signal is applied, and a second pin spaced apart from the edge of the main body by a second distance that is less than the first distance, the second pin including an end terminal to which a second supply voltage is applied, the second supply voltage having a level lower than a level of a first supply voltage corresponding to a power supply to the semiconductor chip.

According to an aspect of an example embodiment, a method of manufacturing a PCB may include forming an internal wiring layer on a plate layer, providing an insulating layer on the plate layer and the internal wiring layer, forming a contact hole penetrating the insulating layer, forming an external wiring layer on the insulating layer, forming a first pin, the first pin including a first tab to which a signal is applied and a first tie-bar having a first length, forming a second pin, the second pin including a second tab to which a ground voltage is applied and a second tie-bar having a second length that is greater than the first length, and separating a resultant product along a cutting line into the PCB having a first edge portion on which the first pin and the second pin are provided.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a plan view of a printed circuit board (PCB) according to one or more example embodiments;
FIG. 2 is a perspective view illustrating portion A of FIG. 1 according to one or more example embodiments;
FIG. 3 is a perspective view illustrating portion B of FIG. 1 according to one or more example embodiments;
FIG. 4 is a plan view illustrating first and second pins according to one or more example embodiments;
FIG. 5 is a plan view illustrating first and second pins according to one or more example embodiments;
FIG. 6 is a plan view illustrating an arrangement of a plurality of pins according to one or more example embodiments;
FIG. 7 is a plan view illustrating an arrangement of a plurality of pins according to one or more example embodiments;
FIG. 8 is a plan view illustrating a plurality of pins according to one or more example embodiments;
FIG. 9 is a plan view of a PCB according to one or more example embodiments;
FIG. 10 is a plan view of a PCB according to one or more example embodiments;
FIGS. 11A, 11B, 11C, 11D, 11E, and 11F are cross-sectional views illustrating a method of manufacturing a PCB, according to one or more example embodiments;
FIGS. 12A, 12B, 12C, 12D, 12E, and 12F are cross-sectional views illustrating a method of treating a surface of a pin, according to one or more example embodiments; and
FIG. 13 is a perspective view illustrating an example of a substrate according to one or more example embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. One or more embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element or layer is referred to as being "directly over," "directly above," "directly on," "directly below," "directly under," "directly beneath," "directly connected to" or "directly coupled to" another element or layer, there are no intervening elements or layers present.

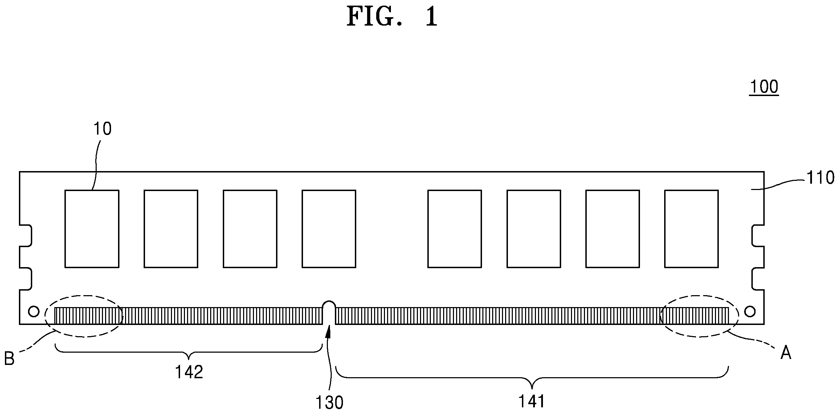

FIG. 1 is a plan view of a printed circuit board (PCB) according to an embodiment.

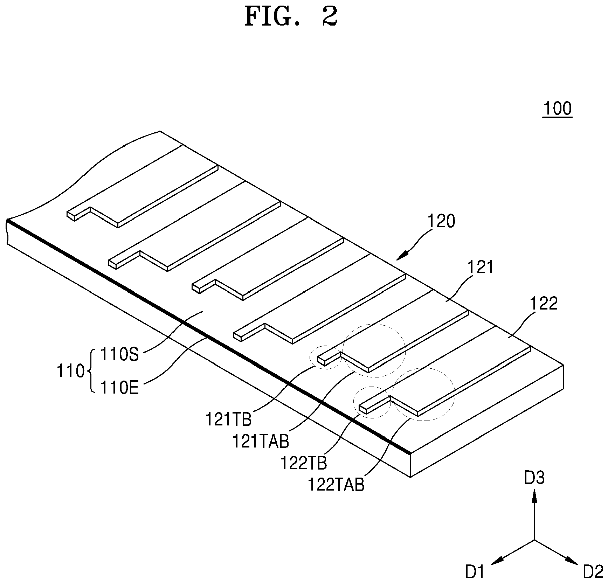

Referring to FIG. 1, a PCB 100 may be a substrate on which one or more semiconductor chips 10 are mounted. A plurality of pins (e.g., pins 120 illustrated in FIG. 2) may be formed near or at one edge (or one edge portion) of the PCB 100. The plurality of pins 120 may constitute a portion of an external wiring layer exposed to the outside of a main body 110. Since an edge in which the plurality of pins 120 are formed is inserted into a slot mounted on a main board, the PCB 100 may be mounted on the main board.

The PCB 100 may be made by coating a conductive foil such as copper (Cu), silver (Ag), or gold (Au) on a flat plate formed by compressing phenol, epoxy glass resin, or the like to a predetermined thickness. A circuit interconnection line is formed by patterning the copper foil (Cu foil) and electronic components, such as semiconductor chips and the like, may be mounted on the PCB 100 through a bump.

The PCB 100 may be a single layer PCB and a double layer PCB. The single layer PCB may be a substrate on which wiring is formed only on one surface (or a first surface) of the main body 110. The double layer PCB may be a substrate on which wiring is formed on both surfaces (or a first surface and a second surface) of the main body 110. In addition, more than three copper foil layers may be formed with three or more layers by using an insulator such as prepreg, and three or more interconnection layers (or, referred to as wiring layers) may be formed on the PCB 100 according to the number of copper foil layers. In addition, wirings (also referred to as interconnection lines) exposed to the outside may be electrically connected to the plurality of pins 120 through contacts and internal wiring. The wirings and the plurality of pins 120 exposed to the outside may constitute an external wiring layer of the PCB 100.

Wirings constituting the external wiring layer may be formed densely with a predetermined pattern in and around a mounting region where the semiconductor chips 10 are mounted. The mounting region in which the semiconductor chips 10 are mounted may be set in a specific region on one surface or both surfaces of the main body 110. In the mounting region, the semiconductor chips 10 may be mounted in a flip-chip manner such that the semiconductor chips 10 and the wirings may be electrically connected with each other. The semiconductor chips 10 mounted on the main body 110 may be memory chips or logic chips. When the semiconductor chip 10 is a memory chip, the semiconductor chip 10 may include dynamic (random access memory (RAM)) (DRAM), static RAM (SRAM), synchronous DRAM (SDRAM), double data rate (DDR) SDRAM (DDR SDRAM), low power DDR (LPDDR), graphics DDR (GDDR) SDRAM, rambus DRAM (RDRAM), flash memory, electrically erasable programming ROM (EEPROM), and the like. The PCB 100, on which such memory chips are mounted, may constitute a memory module. That is, the memory module may include a semiconductor chip 10 implemented as a memory chip, a PCB 100, and the like. In this case, the semiconductor chip 10 may be a DDR5-based memory chip, and the memory module may be a DDR5-based memory module.

In addition, the semiconductor chip 10 may be mounted on only one surface or both surfaces of the main body 110. In one or more embodiments, the number of semiconductor chips 10 mounted on only one surface of the main body 110 may be eight, as shown in FIG. 1, but the number of semiconductor chips 10 mounted on one surface of the main body 110 is not limited to eight. That is, less than or more than eight semiconductor chips 10 may be mounted on both surfaces of the main body 110, respectively. For example, 16 semiconductor chips may be mounted on each of both surfaces of the PCB 100. Although the semiconductor chip 10 is simply shown in a quadrangular shape, the semiconductor chip 10 may be mounted on the PCB 100 in the form of a package sealed by a sealing material rather than mounted on the PCB 100 in the form of a bare chip.

The plurality of pins 120 may be formed on one surface or both surfaces of the main body 110. When a plurality of pins 120 are formed only on one surface of the main body 110, a memory module including the semiconductor chip 10 and the PCB 100 may be referred to as a single in-line memory module (SIMM). When a plurality of pins 120 are formed on both surfaces of the main body 110, the memory module may be referred to as a dual in-line memory module (DIMM). A structure or device into which the PCB 100 is inserted may be referred to as a socket or slot. When the memory module is a SIMM, the number of pins 120 may be 144. However, embodiments are not limited thereto. When the memory module is a DIMM, the number of pins 120 may be 288 and 144 pins may be arranged on both surfaces of the main body 110, respectively. However, embodiments are not limited thereto.

The main body 110 may include a first surface on which at least one semiconductor chip 10 is mounted. In addition, the main body 110 may further include a second surface. When the memory module is a SIMM, the semiconductor chip 10 may not be mounted on the second surface. When the memory module is a DIMM, the semiconductor chip 10 may be mounted on the second surface. When only the memory chip is mounted in the mounting region of the main body 110, the memory module may be referred to as an unbuffered DIMM (UDIMM).

The PCB 100 may further include a notch 130 formed at a predefined position at one edge of the main body 110. A first edge region 141 and a second edge region 142 separated by the notch 130 may be set at one edge of the main body 110. Some of the plurality of pins 120 may be arranged and aligned in the first edge region 141, and the remaining pins of the plurality of pins 120 may be arranged and aligned in the second edge region 142.

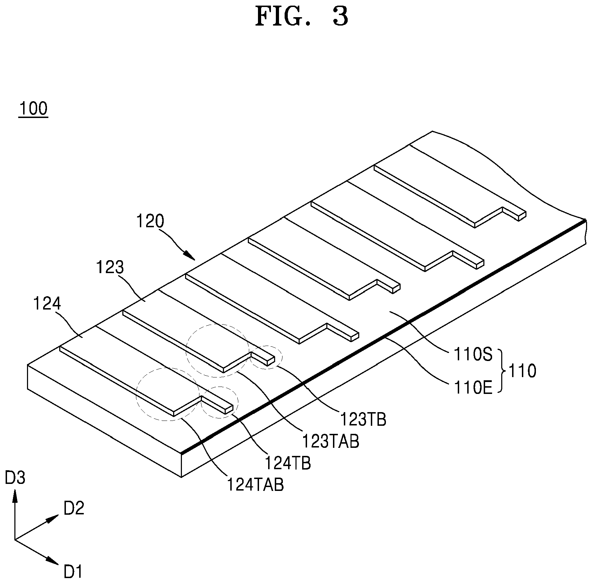

FIG. 2 is a perspective view illustrating portion A of FIG. 1 according to one or more example embodiments. FIG. 3 is a perspective view illustrating portion B of FIG. 1 according to one or more example embodiments.

Referring to FIGS. 1, 2, and 3, the PCB 100 may include the main body 110 and the pins 120 formed on the main body 110. The pins 120 may constitute a portion of an external wiring layer exposed to the outside of the main body 110. The main body 110 may include a plurality of edges and a plurality of surfaces. The pins 120 may be arranged on a first surface 110S of the main body 110 and may be spaced apart from one edge 110E by a predetermined distance.

In one or more embodiments, the plurality of pins 120 may include a signal pin and a ground pin. The signal pin may be a metal member through which a signal generated by communication between the outside and the semiconductor chip 10 passes. The outside may refer to, for example, a processor such as a central processing unit (CPU), a graphics processing unit (GPU), or a neural processing unit (NPU), but embodiments are not limited thereto. The signal generated by communication between the outside and the semiconductor chip 10 may correspond to a data signal including data, a command signal including a command, an address signal including an address, or the like. The signal passing through the signal pin may include a signal transmitted from the outside to the semiconductor chip 10, or a signal being transmitted from the semiconductor chip 10 to the outside. For example, a command signal and/or an address signal may be generated externally and transmitted to the semiconductor chip 10 through a signal pin. For example, a data signal may be generated by the semiconductor chip 10 implemented as a memory chip and transmitted to the outside through a signal pin, or may be generated externally and transmitted to the semiconductor chip 10 through a signal pin. The ground pin may be a metal member to which ground (or a ground voltage) is applied.

Referring to FIGS. 2 and 3, in one or more embodiments, the plurality of pins 120 may include a first pin 121, a second pin 122, a third pin 123, and a fourth pin 124. The first pin 121 and the third pin 123 may be spaced apart from the edge 110E of the main body 110 by a first distance and may have an end (or, an end terminal) to which a signal is applied. The end of the pin coupled to a slot may be referred to as a coupling end. The second pin 122 and the fourth pin 124 may be spaced apart from the edge 110E by a second distance that is less than the first distance and may have an end (or a coupling end or an end terminal) to which a second supply voltage having a level lower than the level of a first supply voltage is applied. The first supply voltage may correspond to a power supply to a memory chip and a core defined in the specification of the joint electron device engineering council (JEDEC), and the second supply voltage may correspond to a power supply return or ground defined in the JEDEC specification.

Referring to FIGS. 1 and 2, for example, the plurality of pins 120 may include a first pin 121, a second pin 122, and the like. The first pin 121 may correspond to a signal pin. The first pin 121 may include a first tab 121TAB and a first tie-bar 121TB. The first tab 121TAB may extend in a first direction D1 parallel to the first surface 110S (for example, toward the edge 100E of the main body 100). In one or more embodiments, the first direction D1 may be any direction on the first surface 110S. In one or more embodiments, the second direction D2 may be parallel to the first surface 110S. In one more embodiments, the edge 110E of the main body 110 extends in the second direction D2. For example, the first direction D1 may be perpendicular to the second direction D2 in which the edge 110E of the main body 110 extends. For example, the first direction D1 may be not perpendicular to the second direction D2 and an angle between 0 degrees and 90 degrees with respect to the first direction D1 and the second direction D2 may be formed. When the PCB 100 is mounted (or coupled) into the slot, a first signal generated by communication between the outside and the semiconductor chip 10 may pass through the first tab 121TAB. The first signal may correspond to, for example, a data signal or a control signal including a command and an address. The first tie-bar 121TB may protrude (or, extend) toward the edge 110E from the end of the first tab 121TAB and may have a first length along the first direction D1. The second pin 122 may correspond to a ground pin. The second pin 122 may include a second tab 122TAB and a second tie-bar 122TB. The second tab 122TAB may be arranged parallel with the first pin 121 with respect to the edge 110E and may extend in the first direction D1 (for example, toward the edge 100E of the main body 100). For example, the first pin 121 and the second pin 122 may be arranged adjacent to each other in the second direction D2. When the PCB 100 is mounted (or coupled) into the slot, a ground voltage having a voltage level of the ground may be applied to the second tab 122TAB. The second tie-bar 122TB may protrude (or, extend) toward the edge 110E from the end of the second tab 122TAB and may have a second length that is greater than the first length of the first tie-bar 121TB along the first direction D1. A plurality of first pins 121 and a plurality of second pins 122 may be repeatedly arranged in the second direction D2 on the first surface 100S.

Referring to FIGS. 1 and 3, for example, the plurality of pins 120 may include a third pin 123, a fourth pin 124, and the like. The third pin 123 may correspond to a signal pin and may include a third tab 123TAB and a third tie-bar 123TB. The fourth pin 124 may correspond to a ground pin and may include a fourth tab 124TAB and a fourth tie-bar 124TB. Since the description of the third pin 123 and the fourth pin 124 is similar to the description of the first pin 121 and the second pin 122 described with reference to FIG. 2, a redundant description thereof is omitted.

In one or more embodiments, in the case of pins included in the same edge region, the position and direction in which the tie-bar is arranged at the end of the pin may be the same. Referring to FIGS. 1 and 2, for example, tie-bars of pins 120 included in the first edge region 141 may be located on the first sides (e.g., the left ends of the tabs) at the ends of the tabs. Referring to FIGS. 1 and 3, for example, tie-bars of pins 120 included in the second edge region 142 may be located on the second sides (e.g., the right ends of the tabs) at the ends of the tabs. However, embodiments are not limited thereto.

In one or more embodiments, pins included in the first edge region 141 may be formed symmetrical about an axis extending along the first direction D1 with pins included in the second edge region 142. That is, the shape of the pin included in the first edge region 141 may be symmetrical to the shape of the pin included in the second edge region 142. Referring to FIGS. 1, 2, and 3, for example, in the case of the first and second pins 121 and 122 included in the first edge region 141, the first and second tie-bars 121TB and 122TB may be located at the left ends of the first and second tabs 121TAB and 122TAB, respectively. In addition, for the third and fourth pins 123 and 124 included in the second edge region 142, the third and fourth tie-bars 123TB and 124TB may be located at the right ends of the third and fourth tabs 123TAB and 124TAB, respectively. However, embodiments are not limited thereto.

According to one or more embodiments, when a user or equipment inserts the PCB 100 into a slot, a ground pin with a relatively closer distance from the edge to the end first comes into contact with a socket, and accordingly, the charges accumulated by static electricity in the memory module are discharged through the ground pin. Accordingly, the damage inflicted on a relatively weak signal pin may be reduced, and the resistance and robustness of the memory module against electro-static discharge (ESD) may be improved.

A groove (e.g., a notch 130) may be formed by removing a portion of the upper surface and the lower surface of the main body 110. Such a groove may be formed in a form in which the thickness of the main body 110 decreases, and by forming a plurality of grooves in the edge 110E, when the PCB 100 is inserted into the slot, the insertion force may be significantly reduced, and accordingly, there is an effect of solving problems, such as the defect of the PCB 100, the slot defect, and the contact failure between the PCB 100 and the slot.

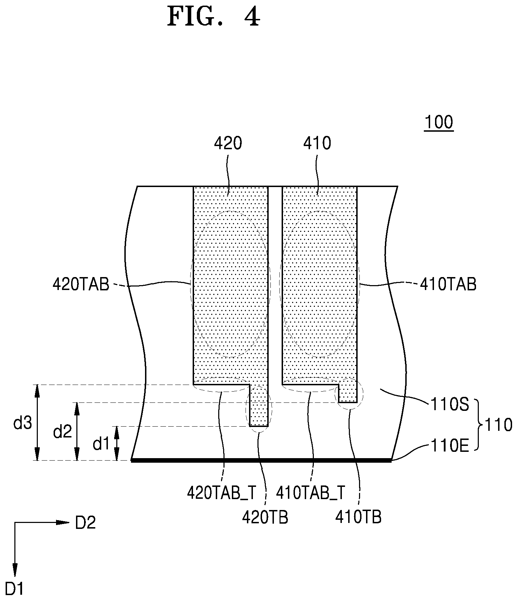

FIG. 4 is a plan view illustrating first and second pins according to one or more example embodiments.

Referring to FIG. 4, a first pin 410 and a second pin 420 may extend in the first direction D1 on the first surface 110S of the main body 110 and may be arranged adjacently in the second direction D2.

The first pin 410 may include a first tab 410TAB and a first tie-bar 410TB. The end of the first pin 410 may include an end 410TAB_T of the first tab 410TAB and an end of the first tie-bar 410TB. The end 410TAB_T of the first tab 410TAB may correspond to a portion excluding the end of the first tie-bar 410TB from the end of the first pin 410.

The second pin 420 may include a second tab 420TAB and a second tie-bar 420TB. The end of the second pin 420 may include an end 420TAB_T of the second tab 420TAB and an end of the second tie-bar 420TB. The end 420TAB T of the second tab 420TAB may correspond to a portion excluding the end of the second tie-bar 420TB from an end of the second pin 420.

In one or more embodiments, the distance between the edge 110E and components of each pin may be referred to as a sub-interval. The end of a tie-bar and the end of a tab may be referred to as a coupling end. Referring to FIG. 4, the sub-interval d1 may correspond to a distance between the end of the tie-bar 420TB of the second pin 420 and the edge 110E of the main body 110, the sub-interval d2 may correspond to a distance between the end of the tie-bar 410TB of the first pin 410 and the edge 110E of the main body 110, and the sub-interval d3 may correspond to a distance between the end 410TAB_T of the tab 410TAB of the first pin 410 and the edge 110E of the main body 110. The sub-interval d3 may also correspond to a distance between the end 420TAB_T of the tab 420TAB of the second pin 420 and the edge 110E of the main body 110.

In one or more embodiments, the end of the first pin 410 may include a first coupling end (i.e., the end of the tie-bar 410TB) facing the edge 110E and spaced apart from the edge 110E by the sub-interval d2 and a second coupling end (i.e., the end 410TAB_T of the tab 410TAB) facing the edge 110E and spaced apart from the edge 110E by a sub-interval d3 that is greater than the sub-interval d2. The end of the second pin 420 may include a third coupling end (i.e., the end of the tie-bar 420TB) facing the edge 110E and spaced apart from the edge 110E by a sub-interval d1 that is less than the sub-interval d2 and a fourth coupling end (i.e., the end 420TAB_T of the tab 420TAB) facing the edge 110E and spaced apart from the edge 110E by the sub-interval d3 that is greater than the sub-interval d1. The sub-interval d3 may correspond to the distance between the end 420TAB_T of the tab 420TAB and the edge 110E, as well as the distance between the end 410TAB_T of the tab 410TAB and the edge 110E, such that this sub-interval is the same or substantially the same for both the first pin 410 and the second pin 420.

The distance between the edge 110E and the end of the tie-bar may have a predetermined range according to the JEDEC specification. Accordingly, in one or more embodiments, the maximum value of the sub-interval d2 may be about 700 micrometers (µm). Moreover, the minimum value of the sub-interval d1 may be about 100 µm. The length of each of the first tie-bar 410TB and the second tie-bar 420TB may be designed and formed in various ways within a range in which the difference value between the sub-interval d2 and the sub-interval d1 is included within about 600 µm. In one or more embodiments, the difference between the sub-interval d2 and the sub-interval d1 may be about 200 µm, but embodiments are not limited thereto. The first tie-bar 410TB may have a first length along the first direction D1 and the second tie-bar 420TB may have a second length that is greater than the first length.

When the user inserts the PCB 100 into the slot, the user may apply a relatively large force to the PCB 100, twist the PCB 100 left or right, or instantly concentrate the force only on one side of the PCB 100. When the user inserts the PCB 100 into the slot as in one or more embodiments described herein, the tie-bar may first contact the slot. Furthermore, electric charges may be accumulated by static electricity in the memory module including the PCB 100. If the tie-bar provided on the signal pin comes into contact with the slot before the ground pin when the memory module charged by static electricity is inserted into the slot, the charges accumulated by static electricity are discharged through the signal pin, which may damage the signal pin with relatively weak resistance.

According to one or more embodiments, when the user inserts the PCB 100 into the slot, the tie-bar provided in the pin may first contact the socket. In this case, a ground pin with a relatively longer tie-bar comes into contact with the socket first, and charges accumulated by static electricity in the memory module may be discharged through the ground pin. Accordingly, damage inflicted on a relatively weak signal pin may be reduced, and resistance and robustness to the ESD of the memory module may be improved. That is, when an ESD evaluation is performed on the memory module of the inventive concept, a charging level when a defect occurs is further increased compared to the prior art.

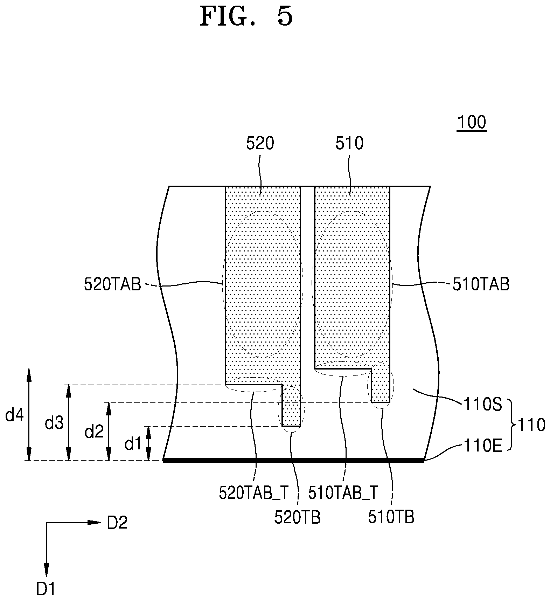

FIG. 5 is a plan view illustrating first and second pins according to one or more embodiments.

Referring to FIG. 5, a first pin 510 and a second pin 520 may be arranged in parallel as described above with reference to FIG. 4, and may each have a tab and a tie-bar (for example, extending toward the edge 100E of the main body 100). The end of the first pin 510 may include an end 510TAB_T of a first tab 510TAB and an end of a first tie-bar 510TB. The end 510TAB_T of the first tab 510TAB may be referred to as a first coupling end. The end of the second pin 520 may include an end 520TAB_T of a second tab 520TAB and an end of a second tie-bar 520TB. The end 520TAB_T of the second tab 520TAB may be referred to as a second coupling end.

Referring to FIG. 5, the sub-interval d1 may correspond to a distance between the end of the tie-bar 520TB of the second pin 520 and the edge 110E of the main body 110, the sub-interval d2 may correspond to a distance between the end of the tie-bar 510TB of the first pin 510 and the edge 110E of the main body 110. The sub-interval d3 may correspond to a distance between the end 520TAB_T of the tab 520TAB of the second pin 520 and the edge 110E of the main body 110. The sub-interval d4 may correspond to a distance between the end 510TAB_T of the tab 510TAB of the first pin 510 and the edge 110E of the main body 110. The size of the sub-interval d2 may be greater than the size of the sub-interval d1. The maximum value of the sub-interval d2 may be about 700 µm. In addition, the minimum value of the sub-interval d1 may be about 100 µm. Furthermore, the sub-interval d3 may be less than the sub-interval d4, such that the end 510TAB_T of the tab 51 0TAB of the first pin 510 is spaced apart from the edge 110E at a distance that is greater than the distance of the end 520TAB_T of the tab 520TAB of the second pin 520 from the edge 110E. The first tie-bar 510TB may have a first length d4-d2 along the first direction D1 and the second tie-bar 520TB may have a second length d3-d1 that is greater than the first length d4-d2.

According to one or more embodiments described herein, when the user inserts the PCB 100 into the slot by twisting the PCB 100, a ground pin having a relatively longer tie-bar comes into contact with the socket first, and charges accumulated by static electricity in the memory module may be discharged through the ground pin. Accordingly, damage inflicted on a relatively weak signal pin may be reduced, and resistance and robustness to the ESD of the memory module may be improved.

The PCB 100 may be inserted into the slot by equipment. In this case, the PCB 100 may be accurately inserted into the slot without twisting or the like, and the end (or the coupling end) of the tab may first contact the slot. However, if the end of the signal pin comes into contact with the slot before the ground pin when the memory module charged by static electricity is inserted into the slot, the charges accumulated by static electricity are discharged through the signal pin, which may damage the signal pin.

According to one or more embodiments, when equipment accurately inserts the PCB 100 into the slot, a ground pin with a relatively closer distance from the edge 110E to the end of the tab first comes into contact with a socket, and accordingly, the charges accumulated by static electricity in the memory module are discharged through the ground pin. Accordingly, damage inflicted on a relatively weak signal pin may be reduced, and resistance and robustness to the ESD of the memory module may be improved.

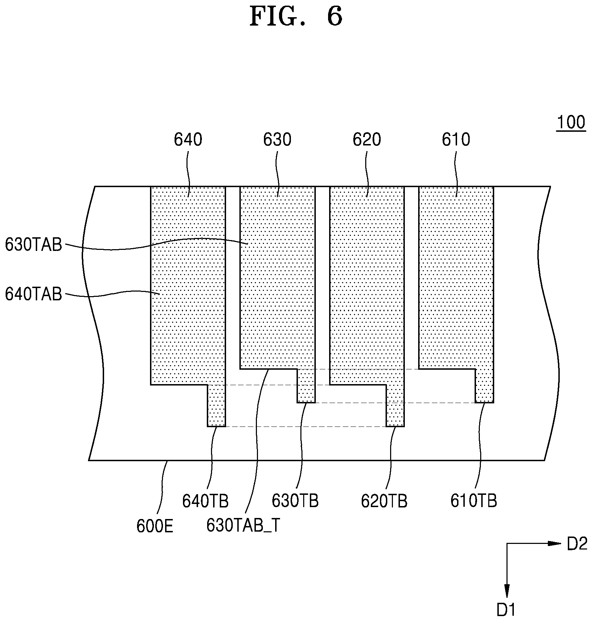

FIG. 6 is a plan view illustrating an arrangement of a plurality of pins according to one or more embodiments.

Referring to FIG. 6, the PCB 100 may include a first pin 610, a second pin 620, a third pin 630, and a fourth pin 640. The first pin 610 and the third pin 630 may correspond to signal pins, and the second pin 620 and the fourth pin 640 may correspond to ground pins. The first pin 610 and the second pin 620 may be the same as those described above with reference to FIGS. 2 to 5. The first pin 610, the second pin 620, the third pin 630, and the fourth pin 640 may be included in the first edge region 141 of FIG. 1 or the second edge region 142 of FIG. 1.

The third pin 630 may have an end spaced apart from one edge (e.g., the edge 600E) by a first distance and to which a third signal is applied, the third signal being different from a first signal applied to the first pin 610. The first distance may be a distance between one edge and an end of the first pin 610. In one or more embodiments, the first signal and the third signal may be signals of the same type but have different values. For example, the first and third signals may be data signals. In one or more embodiments, the first signal and the third signal may be heterogeneous signals. For example, the first signal may be a data signal, the third signal may be a control signal including a command and an address, and vice versa, such the first signal and the third signal may be applied to an embodiment of the inventive concept. The third pin 630 may include a third tab 630TAB and a third tie-bar 630TB. The third tab 630TAB may extend in the first direction D1 (for example, toward the edge 100E of the main body 100). In the third tab 630TAB, a third signal may pass. The third tie-bar 630TB may protrude from the end 630TAB_T of the third tab 630TAB toward the edge 600E and have a third length. In this case, the third length may be less than the second length of the second tie-bar 620TB of the second pin 620. For example, the third length may be the same as the first length of the first tie-bar 610TB of the first pin 610.

The fourth pin 640 may have an end spaced apart from the edge 600E by a second distance and to which a second supply voltage is applied. The second distance may be a distance between the edge 600E and an end of the second pin 620. The second supply voltage may be, for example, a ground (or a ground voltage). The fourth pin 640 may include a fourth tab 640TAB and a fourth tie-bar 640TB. The fourth pin 640 may correspond to the ground pin in the same manner as the second pin 620.

In one or more embodiments, the first pin 610, the second pin 620, the third pin 630, and the fourth pin 640 may be arranged side by side in a parallel direction with respect to the edge 600E.

In one or more embodiments, the first pin 610, the second pin 620, the third pin 630, and the fourth pin 640 may be sequentially arranged and adjacent in the second direction D2. For example, the first pin 610 and the second pin 620 may be adjacent and arranged side by side in the second direction D2, the second pin 620 and the third pin 630 may be adjacent and arranged side by side in the second direction D2, and the third pin 630 and the fourth pin 640 may be adjacent and arranged side by side in the second direction D2. That is, the second pin 620 may be arranged between the first pin 610 and the third pin 630, and the third pin 630 may be arranged between the second pin 620 and the fourth pin 640. However, embodiments are not limited thereto. That is, the signal pins and the ground pins may be sequentially arranged one by one. For example, the first pin 610 may be a DQ4 pin defined by the JEDEC specification, the third pin 630 may be a DQ0 pin defined by the JEDEC specification, and the second pin 620 and the fourth pin 640 may be VSS pins or ground pins defined by the JEDEC specification. However, embodiments are not limited thereto.

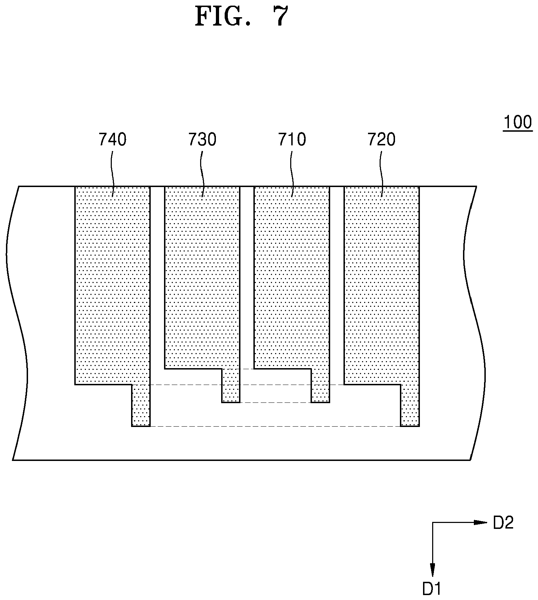

FIG. 7 is a plan view illustrating an arrangement of a plurality of pins according to one or more example embodiments.

Referring to FIG. 7, the PCB 100 may include a first pin 710, a second pin 720, a third pin 730, and a fourth pin 740. The first pin 710 and the third pin 730 may correspond to signal pins, and the second pin 720 and the fourth pin 740 may correspond to ground pins. The first pin 710, the second pin 720, the third pin 730, and the fourth pin 740 may be included in the first edge region 141 or the second edge region 142.

In one or more embodiments, the first pin 710 and the third pin 730 may be arranged adjacent between the second pin 720 and the fourth pin 740. That is, two signal pins may be arranged adjacent to each other, and ground pins may be arranged adjacent to two adjacent signal pins. For example, the first pin 710 may be a DQS0_c pin defined by the JEDEC specification, the third pin 730 may be a DQS0_t pin defined by the JEDEC specification, and the second pin 720 and the fourth pin 740 may be VSS pins or ground pins defined by the JEDEC specification. However, embodiments are not limited thereto.

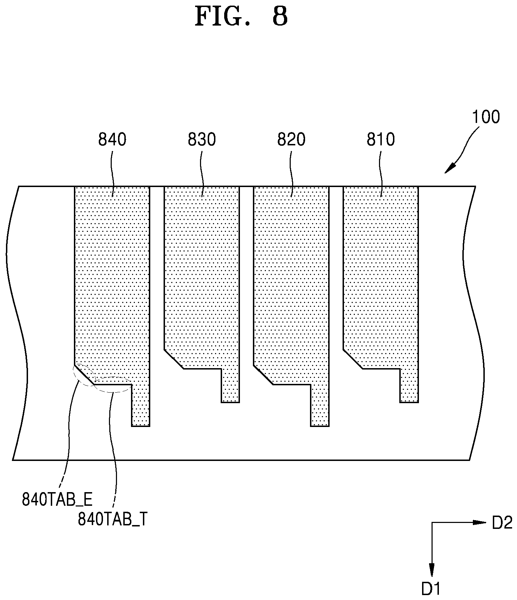

FIG. 8 is a plan view illustrating a plurality of pins according to one or more embodiments.

Referring to FIG. 8, the PCB 100 may include a first pin 810, a second pin 820, a third pin 830, and a fourth pin 840. The first pin 810 and the third pin 830 may correspond to signal pins, and the second pin 820 and the fourth pin 840 may correspond to ground pins. A portion of the tab provided in each of the first pin 810, the second pin 820, the third pin 830, and the fourth pin 840 may be removed so that a tab edge and an end of the tab may be formed. For example, a tab edge 840TAB_E provided in the fourth pin 840 may be formed, and an end 840TAB_T of the tab may be formed. That is, a corner of the tab of the fourth pin 840 may be removed to form the tab edge 840TAB _E, which may form an angle between 0 degrees and 90 degrees with respect to the first direction D1 and/or the second direction D2. A tab edge and an end of the tab may be formed in each of the first pin 810, the second pin 820, and the third pin 830. Accordingly, there is an effect of reducing the manufacturing cost of plating the metal.

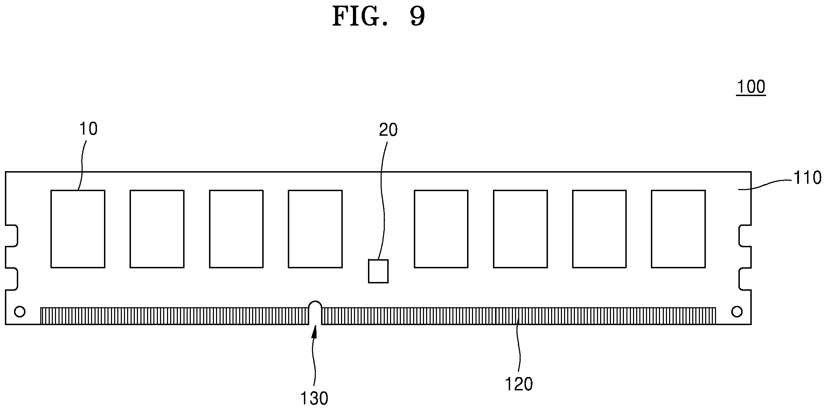

FIG. 9 is a plan view of a PCB according to one or more embodiments.

Referring to FIG. 9, a semiconductor chip 20 that is different from the semiconductor chip 10 may be further mounted on the PCB 100. Although the semiconductor chips 10 and 20 are simply shown in a quadrangular shape, the semiconductor chips 10 and 20 may be mounted on the PCB 100 in the form of a package sealed by a sealing material rather than mounted on the PCB 100 in the form of a bare chip.

The semiconductor chip 20 may be a buffer chip or a registered clock driver (RCD), and the buffer chip may be placed between DRAM and a memory controller to relay data transmission. For example, the semiconductor chip 20 implemented as a buffer chip may be an advanced memory buffer (AMB), which is connected to all DRAMs mounted on memory modules to store data transferred from the memory controller in DRAM, read the requested data from the DRAM, transmit the requested data to the memory controller, and deliver data and request of the memory controller to the AMB of the memory module mounted in the next slot. By providing such a buffer chip, a memory module having a large transmission bandwidth and a high capacity may be implemented. When a buffer chip is additionally mounted in the mounting region of the main body 110, the memory module may be referred to as a registered DIMM (RDIMM), a load reduced DIMM (LRDIMM), or the like. In addition, the memory module may be a DDR5-based memory module.

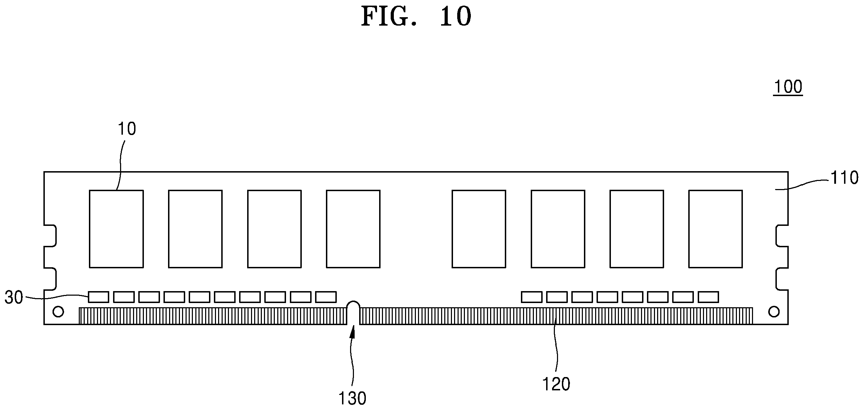

FIG. 10 is a plan view of a PCB according to one or more embodiments.

Referring to FIG. 10, on the PCB 100, DQ resistors 30 (or DQ buffers or data buffers) for stabilizing a data signal or a DQ signal may be further mounted. In this case, the semiconductor chips 10 may be DDR4-based memory chips. Accordingly, the memory module may be a DDR4-based UDIMM. The semiconductor chip 20 of FIG. 9 may be further mounted on the PCB 100 of FIG. 10. Accordingly, the memory module may be a DDR4-based RDIMM or a DDR4-based LRDIMM. According to one or more embodiments described above, the DQ resistors 30 are further mounted on the PCB 100, thereby increasing resistance and robustness against ESD of the memory module.

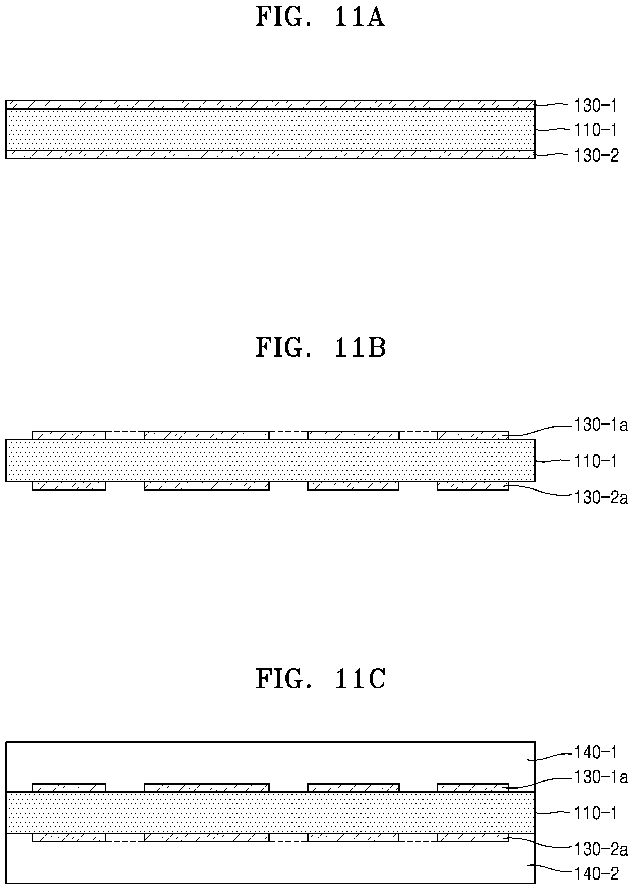

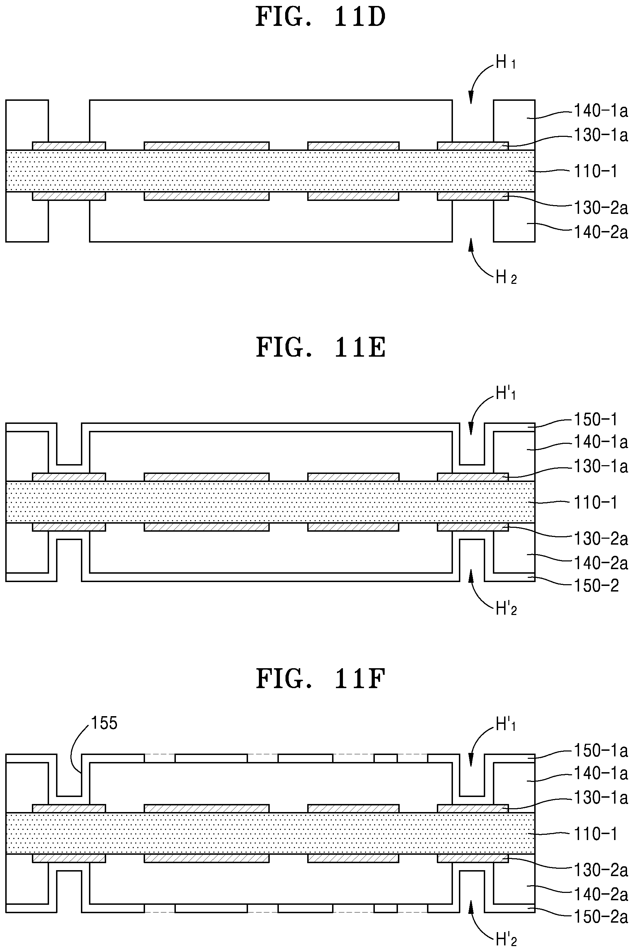

FIGS. 11A, 11B, 11C, 11D, 11E, and 11F are cross-sectional views illustrating a method of manufacturing a PCB, according to one or more example embodiments.

Referring to FIG. 11A, first, a PCB original plate (e.g., a PCB disk) may be prepared. The PCB disk may include a plate layer 110-1 and copper foils 130-1 and 130-2 formed on top and bottom surfaces of the plate layer 110-1. The PCB disk may be referred to as a copper clad laminate (CCL) as a basic material for making a PCB. In addition, in one or more embodiments, copper foils 130-1 and 130-2 may be formed on both sides of the plate layer 110-1, but in some cases, any one copper foil may be formed on only one side of the plate layer 110-1. The plate layer 110-1 may include a resin that is an insulator, for example, epoxy or phenol resin. Although resin has excellent insulation properties, resin has weak strength and has a large dimensional change depending on temperature, so paper, glass woven fabric, reinforcing materials, etc. may be added to form the plate layer 110-1. For example, the plate layer 110-1 may include a material such as FR4 (epoxy resin + glass fiber) or FR2 (phenol resin + paper).

Referring to FIG. 11B, as the copper foils 130-1 and 130-2 are patterned, a first internal wiring 130-1a may be formed on the top surface of the plate layer 110-1 and a second internal wiring 130-2a may be formed on the bottom surface of the plate layer 110-1. In one or more embodiments, wirings may be formed on both surfaces of the plate layer 110-1, but wirings may be formed only on one surface of the plate layer 110-1. An insulating substrate, for example, a PCB having wiring formed only on one side of the plate layer 110-1, may be referred to as a single layer PCB, and a PCB having respective wirings formed on both sides of the plate layer 110-1 may be referred to as a double layer PCB. A process of patterning the copper foils 130-1 and 130-2 may be performed through photolithography. For example, first, a laminate film may be entirely coated on the copper foils 130-1 and 130-2. Then, after a required (or desired) wiring-shaped mask is manufactured, ultraviolet rays may be emitted to the laminate film through the mask. After ultraviolet rays are emitted to the laminated film, the laminate film of the ultraviolet rays-irradiated portion may be removed through a developing process. After the exposed copper foil is etched using the laminate film remaining after removal as an etching mask, the laminate film may be removed, and a process of patterning the copper foil may be performed. In one or more embodiments, although the first internal wiring 130-1a and the second internal wiring 130-2a are formed symmetrically with respect to the plate layer 110-1, the first and second internal wirings 130-1a and 130-2a may not be formed symmetrically in some cases. In addition, the first internal wiring 130-1a and the second internal wiring 130-2a may include copper, but the materials of the first internal wiring 130-1a and the second internal wiring 130-2a are not limited to copper. For example, the first internal wiring 130-1a and the second internal wiring 130-2a may include various metals such as aluminum, silver, and nickel. In addition, the first internal wiring 130-1a and the second internal wiring 130-2a may include a single layer or multiple layers.

Referring to FIG. 11C, after the first internal wiring 130-1a and the second internal wiring 130-2a are formed, insulators such as prepregs may be laminated on both surfaces of the plate layer 110-1, and thus, upper and lower insulating layers 140-1 and 140-2 may be formed. The prepreg may be an intermediate material for a fiber-reinforced composite material, and may indicate a molding material in which matrix resins are preliminarily injected (impregnated) into a reinforcing fiber. In general, the prepreg may be stacked on the plate layer 110-1, heated, pressed, and then cured to form a multi-layered PCB substrate. In one or more embodiments, a triple-layer PCB may be formed by stacking prepregs on both surfaces of the plate layer 110-1, but the PCB of one or more embodiments described herein is not limited to the triple-layer. For example, a PCB of five or more layers may be formed by stacking four or more prepregs. The plate layer 110-1, the first internal wiring 130-1a, the second internal wiring 130-2a, and the upper and lower insulating layers 140-1 and 140-2 may be configured in the main body 110 of the PCB 100. An insulator such as a prepreg may be stacked when the copper foil is included in the outermost layer other than the insulator. For example, the process of FIG. 11C may be carried out while the copper foil is included on both sides of the plate layer 110-1, and then the processes of FIGS. 11D to 11F may be carried out.

Referring to FIG. 11D, contact holes H₁ and H₂ penetrating the upper and lower insulating layers 140-1a and 140-2a may be formed. Portions of the first internal wiring 130-1a and the second internal wiring 130-2a may be exposed through the contact holes H₁ and H₂. The contact holes H₁ and H₂ may be formed through various methods. For example, the contact holes H₁and H₂ may be formed based on a drill or a laser. Furthermore, the contact holes H₁ and H₂ may be formed through an etching process such as photolithography. In one or more embodiments, although the contact holes H₁ and H₂ are formed in a symmetrical structure with respect to the plate layer 110-1, the contact holes H₁ and H₂ may not be formed symmetrically in some cases.

Referring to FIG. 11E, after contact holes H₁ and H₂ are formed, plating layers 150-1 and 150-2 may be formed on the upper and lower insulating layers 140-1a and 140-2a, and the plating layers 150-1 and 150-2 are formed in the contact holes H₁ and H₂ to form contact holes H'₁ and H'₂. The plating layers 150-1 and 150-2 may be formed through non-electrolyte plating and electrolyte plating. For example, non-electrolytic plating may be first performed, and then electrolyte plating may be performed using a non-electrolyte plating layer as a seed metal. As illustrated, the plating layers 150-1 and 150-2 may be formed not only on the upper and lower insulating layers 140-1a and 140-2a but also inside the contact holes H'₁ and H'₂. The plating layer portions on the top surfaces of the upper and lower insulating layers 140-1a and 140-2a may be electrically connected to the first and second internal wirings 130-1a and 130-2a through the plating layer portions formed in the contact holes H'₁ and H'₂. In one or more embodiments, the plating layers 150-1 and 150-2 may include copper of the same material as the first and second internal wirings 130-1a and 130-2a. In some cases, the plating layers 150-1 and 150-2 may include a metal different from copper, such as Ni or Ni/Cu. By the process according to FIG. 11E, a step difference between an end of a tab provided in the ground pin and an end of a tab provided in the signal pin may be formed as shown in FIG. 5.

Referring to FIG. 11F, a patterning process may be performed on the plating layers 150-1 and 150-2, thereby forming a first external wiring 150-1a and a second external wiring 150-2a. The patterning of the plating layers 150-1 and 150-2 may be performed through an etching method similar to the patterning of the copper foils described above. The plating layers inside the contact holes H'₁ and H'₂ may be maintained, and contacts 155 connecting the first external wiring 150-1a and the second external wiring 150-2a to the first and second internal wirings 130-1a and 130-2a may be formed. The first external wiring 150-1a and the second external wiring 150-2a may include external wiring layers exposed to the outside in the PCB. The external wiring layer may include wirings exposed in a region where a chip is mounted and pins exposed in an edge portion.

Thereafter, the final PCB may be completed through a photo solder resist coating process, a surface treatment process such as a plating or an organic solderability preservative (OSP) process using nickel, gold, etc., only in a plating region of pins, a routing process, a bare board test (BBT) process, etc. The routing process may refer to a process of cutting and separating a large original substrate into individual PCBs, and the BBT process refers to an electrical test process for an individual PCB.

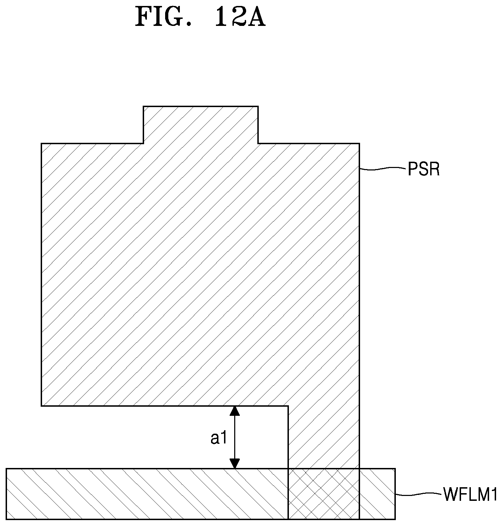

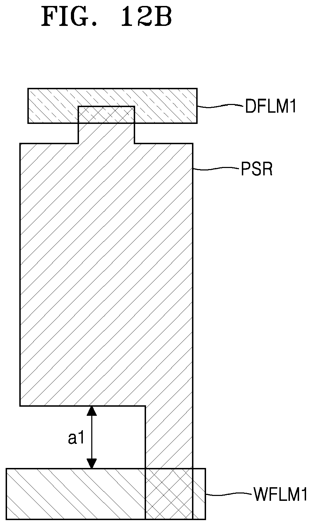

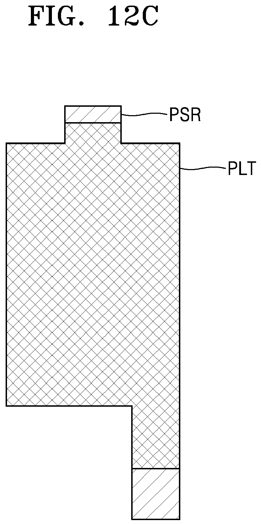

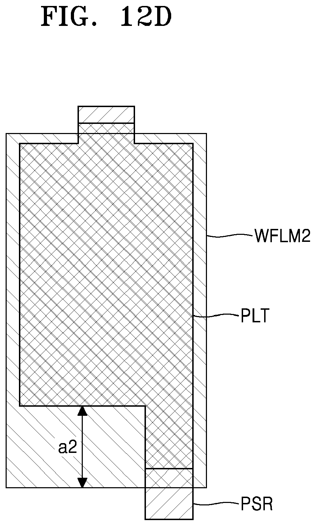

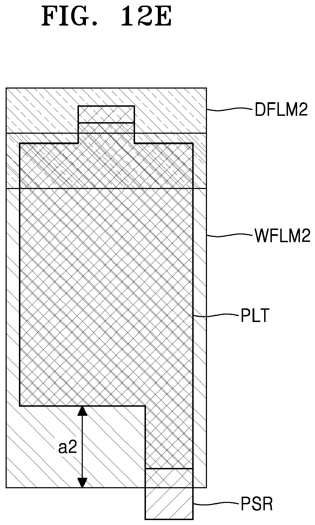

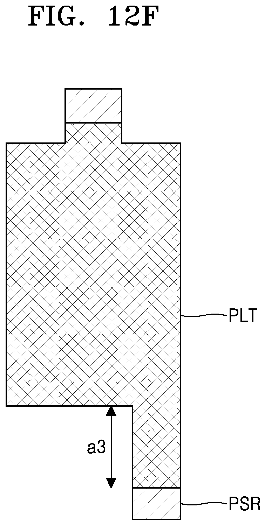

FIGS. 12A, 12B, 12C, 12D, 12E, and 12F are cross-sectional views illustrating a method of treating a surface of a pin, according to one or more example embodiments. Specifically, FIGS. 12A, 12B, 12C, 12D, 12E, and 12F are cross-sectional views illustrating a surface treatment process of performing a plating process on a plating region of a pin to form a signal pin and a ground pin according to embodiments.

Referring to FIGS. 12A, 12B, 12C, 12D, 12E, and 12F, an operation of forming a first pin including a first tab to which a signal is applied and a first tie-bar having a first length from the resultant structure of forming an external wiring layer, and a second pin including a second tab to which a ground voltage is applied and a second tie-bar having a second length longer than the first length may be performed.

Referring to FIG. 12A, after the photo solder resist coating process is performed, a first wet film WFLM1 may be arranged on a portion of the tie-bar in the coating region PSR so that a portion of the tie-bar is masked during plating. The portion where the first wet film WFLM1 is arranged may correspond to a non-plating region. The distance a1 between the end of the first wet film WFLM1 and the end of the tab may be about 38 µm, but embodiments are not limited thereto.

Referring to FIG. 12B, a first dry film DFLM1 may be arranged on a portion of the tab in the coating region PSR, and thus a portion of the tab may be masked during plating. The distance a1 may be about 38 µm, but embodiments are not limited thereto.

Referring to FIG. 12C, plating using a metal such as nickel or gold may be performed in a plating region PLT except for the portion masked by the first dry film DFLM1 and the first wet film WFLM1 in the coating region PSR, and a stripping process for removing the first dry film DFLM1 and the first wet film WFLM1 may be performed.

Referring to FIG. 12D, a second wet film WFLM2 may be arranged on a non-plated region corresponding to a portion of the tie-bar in the coating region PSR, a portion corresponding to the tie-bar in the plating region PLT, and a portion corresponding to the tab in the plating region PLT. Thus, a region in which the second wet film WFLM2 is arranged may be masked. A distance a2 from the end of the tab to the end of the second wet film WFLM2 may be about 95 µm, but embodiments are not limited thereto.

Referring to FIG. 12E, a second dry film DFLM2 may be arranged in the non-plated region corresponding to a portion of the tab in the coating region PSR and on a portion of the plating region PLT so that a region in which the second dry film DFLM2 is arranged may be masked. The distance a2 may be about 95 µm, but embodiments are not limited thereto.

Referring to FIG. 12F, a portion of the tie-bar of the coating region PSR may be etched in a state in which the second wet film WFLM2 and the second dry film DFLM2 are arranged, and a stripping process for removing the second dry film DFLM2 and the second wet film WFLM2 may be performed. A length a3 of the remaining tie-bar after the etching process for a portion of the tie-bar may be about 130 µm at maximum, but embodiments are not limited thereto.

In one or more embodiments, the pin on which the processes illustrated in FIGS. 12A, 12B, 12C, 12D, 12E, and 12F are performed may be a signal pin, but embodiments are not limited thereto. According to embodiments, the processes shown in FIGS. 12A, 12B, 12C, 12D, 12E, and 12F are performed on the ground pin and the signal pin, where the process of etching the tie-bar may be different for each pin so that the length of the tie-bar provided in the ground pin is greater than the length of the tie-bar provided in the signal pin.

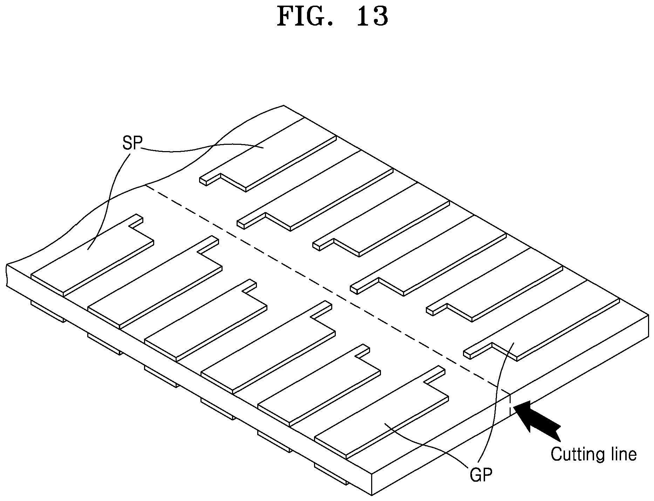

FIG. 13 is a perspective view illustrating an example of a substrate according to one or more example embodiments.

Referring to FIG. 13, the PCB manufacturing process may include a series of processes as shown in FIGS. 11A to 12F on a large original substrate and a process of separating the original substrate into individual PCBs along a cutting line. Referring to FIG. 13, for example, an operation of separating the resultant product having an external wiring layer formed on an original substrate according to a cutting line and separating the resultant product into individual PCBs having a first edge on which a first pin and a second pin are arranged is performed. In the PCB manufacturing process of the inventive concept, the ground pins GP and the signal pins SP may have tie-bars of different lengths, and distances between an end of a tab provided in each of the ground pins GP and the signal pins SP and an edge of the PCB may be different according to embodiments.

Each of one or more embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A printed circuit board, PCB, comprising:
a main body (110) having an edge (110E) and a first surface (110S) on which a semiconductor chip (10) is provided;
a first pin (121, 410, 510, 610, 710, 810) comprising:
a first tab (121TAB, 410TAB, 510TAB) extending in a first direction (D1) parallel to the first surface (110S) toward the edge (110E) of the main body (110) and configured to receive a first signal corresponding to communication between the outside and the semiconductor chip (10); and
a first tie-bar (121TB, 410TB, 510TB) protruding from an end of the first tab (121TAB, 410TAB, 510TAB) toward the edge (110E) of the main body (110), the first tie-bar (121TB, 410TB, 510TB) having a first length along the first direction (D1); and
a second pin (122, 124, 420, 520, 620, 720, 820) adjacent to the first pin (121, 410, 510, 610, 710, 810), the second pin (122, 124, 420, 520, 620, 720, 820) comprising:
a second tab (122TAB, 124TAB, 420TAB, 520TAB) extending in the first direction (D1) toward the edge (110E) of the main body (110) and configured to receive a ground voltage of a ground; and
a second tie-bar (122TB, 124TAB, 420TB, 520TB) protruding from an end of the second tab (122TAB, 124TAB, 420TAB, 520TAB) toward the edge (110E) of the main body (110), the second tie-bar (122TB, 124TAB, 420TB, 520TB) having a second length that is greater than the first length along the first direction.

2. The PCB of claim 1, wherein a first sub-interval (d1) between the edge (110E) of the main body (110) and an end of the first tie-bar (121TB, 410TB, 510TB) is greater than a second sub-interval (d2) between the edge (110E) of the main body (110) and an end of the second tie-bar (122TB, 124TB, 420TB, 520TB).

3. The PCB of claim 2, wherein the first sub-interval (d1) is less than or equal to 700 micrometers.

4. The PCB of claim 2 or 3, wherein the second sub-interval (d2) is at least 100 micrometers.

5. The PCB of any one of claims 1 to 4, wherein a third sub-interval (d4) between an end of the first tab (121TAB, 410TAB, 510TAB) and the edge (110E) of the main body (110) is greater than or equal to a fourth sub-interval (d3) between an end of the second tab (122TAB, 124TAB, 420TAB, 520TAB) and the edge (110E) of the main body (110).

6. The PCB of any one of claims 1 to 5, wherein the main body (110) further comprises:
a notch (130) at the edge (110E) of the main body (110);
a first edge region (141) on a first side of the main body (110); and
a second edge region (142) on a second side of the main body (110),
wherein the notch (130) is between the first edge region (141) and the second edge region (142),
wherein the first pin (121, 410, 510, 610, 710, 810) and the second pin (122, 124, 420, 520, 620, 720, 820) are both in the first edge region (141) or the second edge region (142), and
wherein the first tie-bar (121TB, 410TB, 510TB) and the second tie-bar (122TB, 420TB, 520TB) are located on a same side of the first pin (121, 410, 510, 610, 710, 810) and the second pin (122, 124, 420, 520, 620, 720, 820), respectively.

7. The PCB of any one of claims 1 to 5, wherein the main body (110) further comprises:
a notch (130) at the edge (110E) of the main body (110);
a first edge region (141) on a first side of the main body (110); and
a second edge region (142) on a second side of the main body (110),
wherein the notch (130) is between the first edge region (141) and the second edge region (142),
wherein the first pin (121) is in the first edge region (141),
wherein the first tie-bar (121TB) is located on a first side of the first pin (121),
wherein the second pin (124) is in the second edge region (142), and
wherein the second tie-bar (124TAB) is located on a second side of the second pin (124), the second side of the second pin (124) being different from the first side of the first pin (121).

8. The PCB of any one of claims 1 to 7, further comprising a third pin (630, 730, 830) comprising:
a third tab (630TAB) extending in the first direction (D1) toward the edge (110E) of the main body (110) and configured to receive a second signal that is different from the first signal; and
a third tie-bar (630TB) protruding from an end of the third tab (630TAB) toward the edge (110E) of the main body (110), the third tie-bar (630TB) having a third length that is less than the second length along the first direction.

9. The PCB of claim 8, wherein the first pin (610, 810), the second pin (620, 820), and the third pin (630, 830) are sequentially arranged in a second direction (D2) perpendicular to the first direction (D1),
wherein the first pin (610, 710, 810) and the second pin (620, 820) are adjacent to each other, and
wherein the second pin (620, 820) and the third pin (630, 830) are adjacent to each other.

10. The PCB of claim 8, wherein the first pin is adjacent to the third pin, and wherein the third pin is adjacent to the second pin and is between the first pin and the second pin.

11. A method of manufacturing a printed circuit board, PCB, the method comprising:
forming an internal wiring layer (130-1a) on a plate layer (110-1);
providing an insulating layer (140-1) on the plate layer and the internal wiring layer (130-1a);
forming a contact hole (H1) penetrating the insulating layer (140-1);
forming an external wiring layer (150-1a) on the insulating layer (140-1);
forming a first pin (121, 410, 510, 610, 710, 810), the first pin (121, 410, 510, 610, 710, 810) comprising:
a first tab (121TAB, 410TAB, 510TAB) to which a first signal is applied and a first tie-bar (121TB, 410TB, 510TB) having a first length;
forming a second pin (122, 124, 420, 520, 620, 720, 820), to form a resultant product, the second pin (122, 124, 420, 520, 620, 720, 820) comprising:
a second tab (122TAB, 124TAB, 420TAB, 520TAB) to which a ground voltage is applied and a second tie-bar (122TB) having a second length that is greater than the first length, and
separating the resultant product along a cutting line into the PCB having an edge of a main body (110) on which the first pin (121, 410, 510, 610, 710, 810) and the second pin (122, 124, 420, 520, 620, 720, 820) are provided.

12. The method of claim 11, wherein a first sub-interval (d1) between the edge (110E) of the main body (110) and an end of the first tie-bar (121TB, 410TB, 510TB) is greater than a second sub-interval (d2) between the edge of the main body (110) and an end of the second tie-bar (122TB, 124TB, 420TB, 520TB).

13. The method of claim 11 or 12, wherein a third sub-interval (d4) between an end of the first tab (121TAB, 410TAB, 510TAB) and the edge (110E) of the main body (110) is greater than or equal to a fourth sub-interval (d3) between an end of the second tab (122TAB, 124TAB, 420TAB, 520TAB) and the edge (110E) of the main body (110).

14. The method of any one of claims 11 to 13, further comprising forming a notch (130) at the edge of the main body (110) on which an external wiring layer is formed,
wherein the notch (130) is between a first edge region (141) on a first side of the main body (110) and a second edge region (142) on a second side of the main body (110),
wherein the first pin (121, 410, 510, 610, 710, 810) and the second pin (122, 420, 520, 620, 720, 820) are both in the first edge region (141) or the second edge region (142), and
wherein the first tie-bar (121TB, 410TB, 510TB) and the second tie-bar (122TB, 420TB, 520TB) are located on a same side of the first pin (121, 410, 510, 610, 710, 810) and the second pin (122, 420, 520, 620, 720, 820), respectively.

15. The method of any one of claims 11 to 14, further comprising a third pin (630, 730, 830) parallel to the first pin (610, 710, 810) and the second pin (610, 720, 810) on the the main body (110), before the separating the resultant product along the cutting line into the PCB,
wherein the third pin (630, 730, 830) comprises a third tab to which a second signal different from the first signal is applied and a third tie-bar having a third length that is less than the second length.
